# FASCICULE DE BREVET EUROPEEN

(11) **EP 0 505 975 B1**
(45) Date de publication et mention de la délivrance du brevet: **30.08.1995**
(21) Numéro de dépôt: 92105036.5
(22) Date de dépôt: 24.03.1992
(51) Int. Cl.: H01L 39/14

(54) **Conducteur supraconducteur possédant une protection améliorée contre les transitions partielles**
Supraleiter mit verbessertem Schutz gegen partielle Übergänge
Superconductor having improved protection against partial transitions

(30) Priorité: 28.03.1991 FR 9103770
(43) Date de publication de la demande: 30.09.1992
(73) Titulaire: GEC ALSTHOM SA, 75116 Paris (FR)
(72) Inventeur: Verhaege, Thierry, F-91160 Saulx les Chartreux (FR); Fevrier, Alain, F-78310 Maurepas (FR); Lacaze, Alain, F-90850 Essert (FR); Laumond, Yves, F-90400 Danjoutin (FR)
(74) Mandataire: Weinmiller, Jürgen

(56) Documents cités:
- EP-A- 0 440 127
- FR-A- 2 354 614
- PATENT ABSTRACTS OF JAPAN, vol. 9, no. 320 (P-413) 14 Décembre 1985 & JP-A-60 147 656

## Description

La présente invention concerne un conducteur supraconducteur protégé des transitions partielles.

Les conducteurs supraconducteurs peuvent subir accidentellement, ou dans des conditions de fonctionnement particulières, des transitions partielles c'est-à-dire le passage à l'état résistif d'une zone limitée du conducteur. Cette zone est initialement très petite, puis elle s'étend progressivement en raison de l'échauffement induit par effet Joule. L'échauffement rapide et intense et les tensions élevées qui apparaissent aux bornes de la zone transitée risquent d'endommager le conducteur.

Les conducteurs supraconducteurs contiennent généralement une proportion importante de cuivre ou d'aluminium, proportion jugée nécessaire pour leur protection en cas de transition. En effet, le cuivre ou l'aluminium présentant à froid une résistivité 1000 à 10 000 fois moins élevée que celle du matériau supraconducteur après transition ou d'un alliage comme le cupro-nickel, ceci permet de réduire considérablement l'effet Joule et l'échauffement qui en résulte à courant donné.

En général, la transition se propage lentement n'entraînant ainsi qu'une lente décroissance du courant, insuffisante pour empêcher une dégradation thermique. On a donc recours à divers systèmes de protection.

On connaît des dispositifs de protection active ayant pour fonction de détecter la transition et d'agir sur le circuit d'alimentation de façon à obtenir une décroissance plus rapide du courant. Cependant, la vitesse de décroissance du courant est limitée par la tension maximale acceptable aux bornes du bobinage supraconducteur.

Afin de procurer un système amélioré de protection contre les transitions partielles, on propose un système de protection passive assurant des vitesses de propagation de la zone transitée particulièrement élevées.

Ceci a pu être obtenu grâce à la présence d'un ou de plusieurs brins ou rubans faiblement résistifs mais non supraconducteurs mis en simple contact mécanique, sans cohésion, avec un ou plusieurs brins supraconducteurs.

L'invention a donc pour objet un conducteur supraconducteur protégé contre les transitions partielles comprenant une zone supraconductrice, formée de filaments supraconducteurs noyés dans une matrice métallique non supraconductrice, et une zone métallique non supraconductrice, caractérisé en ce que la résistivité à froid de la zone métallique non supraconductrice est au moins deux fois plus faible que la résistivité globale à froid de la zone supraconductrice à l'état transité, les zones supraconductrice et métallique non supraconductrice étant en simple contact mécanique, sans cohésion.

L'invention concerne un système de protection passive où l'on cherche à obtenir une extension rapide de la zone transitée entraînant du fait de sa résistance ohmique une décroissance rapide du courant.

L'invention sera mieux comprise et d'autres avantages et particularités apparaîtront à la lecture de la description qui va suivre, donnée à titre non limitatif, accompagnée des dessins annexés parmi lesquels :
- la figure 1 est une vue en coupe transversale d'un conducteur supraconducteur selon l'invention,
- la figure 2 est une vue en coupe longitudinale d'un conducteur supraconducteur selon l'invention le long duquel se propage une zone transitée,
- la figure 3 est une vue en coupe transversale d'un monobrin supraconducteur selon l'invention.

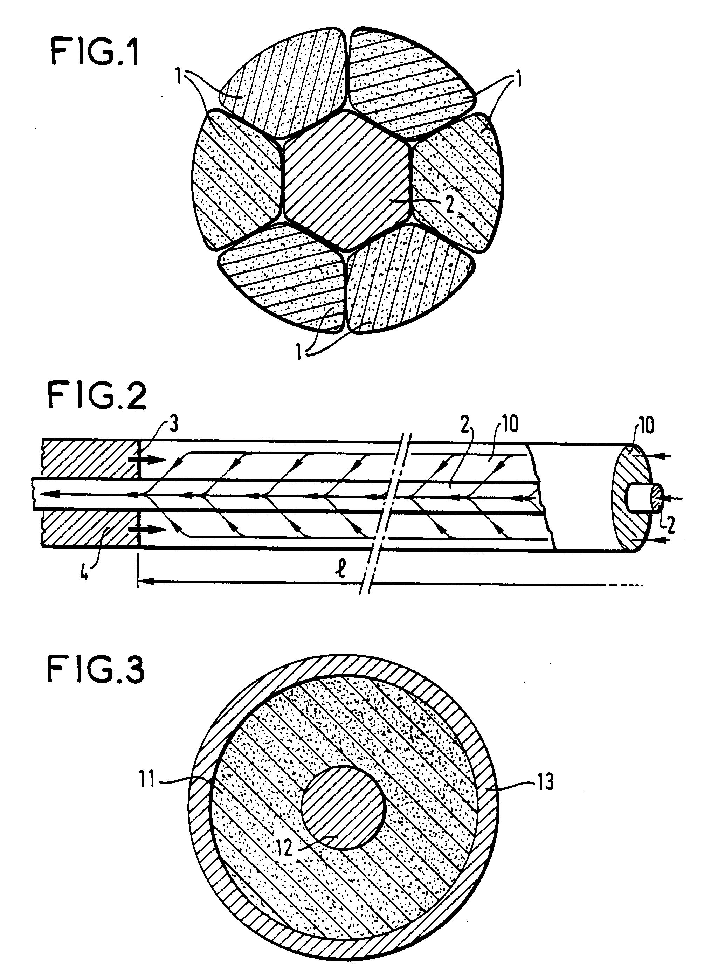

La figure 1 est une vue en coupe d'un conducteur supraconducteur selon l'invention. Il est formé de brins supraconducteurs 1 disposés autour d'un brin central 2 en matériau non supraconducteur. Chaque brin supraconducteur peut être composé de filaments, par exemple en niobium-titane, noyés dans une matrice en alliage de cupro-nickel. Le brin central 2 est réalisé en totalité ou en partie dans un matériau non supraconducteur faiblement résistif tel que le cuivre ou l'aluminium.

Lors de la formation de ce conducteur supraconducteur, on a fait en sorte que le brin central 2 soit en simple contact mécanique avec les brins supraconducteurs 1. Par contact mécanique, on entend une proximité immédiate entre le brin central et les brins supraconducteurs, mais sans la cohésion qu'apporterait par exemple une extrusion à chaud ou un étamage. L'absence de cohésion entre le brin central et les brins supraconducteurs signifie que le brin central doit pouvoir être séparé des brins supraconducteurs par simple action mécanique.

Les matériaux constituant le conducteur supraconducteur sont choisis tels que la résistivité du brin central soit beaucoup plus faible que la résistivité des brins supraconducteurs à l'état transité (par exemple du cuivre pour le brin central et du cupro-nickel pour la matrice des brins supraconducteurs).

Avec ces résistivités et l'absence de cohésion entre le brin central et les brins supraconducteurs, on accroît la vitesse de propagation de la transition à cause du phénomène de transfert de courant.

La figure 2 illustre ce phénomène de transfert de courant. Sur cette figure, on a représenté sous la référence 10 l'ensemble des brins supraconducteurs entourant le brin central 2. Le conducteur est représenté avec le front de propagation 3 de la zone transitée se déplaçant dans le sens indiqué par les flèches. La zone hachurée 4 représente la zone qui a déjà transité.

L'absence de cohésion entre le brin central et les autres brins crée des résistances de contact imposant une longueur l de transfert du courant entre brins supraconducteurs et brin central grande par rapport au diamètre du conducteur. Les lignes de courant, figurant le passage de la zone supraconductrice au brin central, ont été représentées schématiquement sur la figure 2.

En zone transitée, le brin central faiblement résistif transporte une grande part du courant alors que suffisamment loin en aval du front de propagation, le supraconducteur transporte la totalité du courant. Pour que le courant puisse passer il faut une grande section de passage donc une longueur de transfert l importante. Sans résistance de contact, la longueur de la zone de transfert serait réduite, comparable au diamètre du conducteur.

L'effet Joule dans la zone de transfert de courant produit, en aval du front de propagation, l'élévation de température nécessaire à sa progression rapide. Un gain en vitesse de propagation d'un ou de deux ordres de grandeur peut facilement être obtenu par rapport aux conducteurs supraconducteurs habituels pour lesquels le seul moteur de la propagation est la diffusion de la chaleur provenant de la zone transitée.

A titre d'exemple, pour un conducteur supraconducteur du type de la figure 1 (6 brins supraconducteurs autour d'un brin central) de 0,5 mm de diamètre et dont le brin central fait 0,18 mm de diamètre, on a obtenu une longueur l de l'ordre de 30 mm.

Sans résistance de contact entre le brin central et les brins supraconducteurs, le front de propagation de la transition se déplace à une vitesse de l'ordre de 30 à 100 m/s. Avec des résistances de contact, cette vitesse peut dépasser 1 Km/s.

L'invention permet d'éliminer une partie ou même la totalité du métal faiblement résistif dans la zone supraconductrice, cette partie (ou totalité) étant remplacée par une quantité plus petite de ce métal dans la zone non supraconductrice. Ceci présente de nombreux avantages annexes:
- densité globale de courant accrue,
- augmentation de la résistance linéique du conducteur accélérant encore la décroissance du courant,
- réduction des pertes par courants induits en régime variable,
- utilisation possible de matrices de cuivre allié au nickel, au manganèse, etc., pour éviter les effets de proximité malgré le faible espacement.

L'invention peut s'appliquer, avec des caractéristiques dimensionnelles différentes, au cas d'un conducteur destiné au régime alternatif (50-60 Hz) ou d'un conducteur constitutif par exemple d'une bobine de champ pulsé. Ce conducteur peut être l'élément de base à partir duquel sont réalisés des conducteurs assemblés de plus grande capacité.

Dans une version 50-60 Hz, les brins peuvent avoir des dimensions de l'ordre de 0,2 mm et être torsadés au pas de 1 mm. Ils peuvent comprendre des filaments de 0,15»m de niobium-titane espacés de 0,15 »m dans une matrice de cupro-nickel et être dépourvus de cuivre. Le brin central peut alors comporter de l'ordre de 10 % de cuivre sous forme de filaments dans une matrice de cupro-nickel.

Dans une version adaptée à la production de champs intenses pulsés, les brins peuvent avoir des diamètres de 0,5 à 1 mm (des valeurs plus élevées pouvant compromettre leur stabilité électromagnétique) et sont torsadés. Ils comportent avantageusement des filaments de niobium-titane de diamètre réduit (environ 1 »m) espacés de 0,15 »m dans une matrice de cupro-nickel. Une telle disposition est très favorable à la réduction des pertes et à l'augmentation de la densité globale de courant. Les filaments sont groupés par paquets, séparés par une faible épaisseur de cuivre constituant un réseau maillé pouvant évacuer la chaleur produite.

Le cuivre ne représente plus que 5 à 10 % de la section du brin. Le brin central peut être en cuivre éventuellement cloisonné de cupro-nickel.

L'invention s'étend également au cas d'un monobrin supraconducteur dans lequel la zone filamentaire fortement résistive serait en contact sans cohésion avec une âme et/ou une couronne métallique faiblement résistives. Ce cas est représenté à la figure 3 où la zone filamentaire 11 entoure sans cohésion l'âme 12, un tube 13 entourant, également sans cohésion, la zone filamentaire.

L'absence de cohésion peut être dans ce cas provoquée par l'une des méthodes suivantes :
- assemblage d'une billette dont les éléments faiblement résistifs sont couverts d'une pellicule de graisse ou d'oxyde,
- extrusion à température réduite ou à froid,
- gainage et étirage sans extrusion.

## Revendications

1. Conducteur supraconducteur protégé contre les transitions partielles comprenant une zone supraconductrice, formée de filaments supraconducteurs noyés dans une matrice métallique non supraconductrice, et une zone métallique non supraconductrice, caractérisé en ce que la résistivité à froid de la zone métallique non supraconductrice est au moins deux fois plus faible que à la résistivité globale à froid de la zone supraconductrice à l'état transité, les zones supraconductrice et métallique non supraconductrice étant en simple contact mécanique, sans cohésion.

2. Conducteur supraconducteur selon la revendication 1, caractérisé en ce qu'il constitue un brin unique, la zone métallique non supraconductrice étant constituée par une âme (12) située au centre d'une zone supraconductrice unique (11) et/ou par une couronne (13) entourant la zone supraconductrice (11).

3. Conducteur supraconducteur selon la revendication 1, caractérisé en ce que la zone supraconductrice est constituée par un ou plusieurs brins ou rubans supraconducteurs, la zone métallique non supraconductrice étant constituée par un ou plusieurs brins ou rubans.

4. Conducteur supraconducteur selon la revendication 3, caractérisé en ce que la zone métallique non supraconductrice est constitué par un brin central (2), la zone supraconductrice étant constituée par plusieurs brins supraconducteurs (1) disposés autour du brin central.

## Patentansprüche

1. Gegen partielle Übergänge geschützter Supraleiter, der eine supraleitende Zone, die von supraleitenden Fäden gebildet wird, die in eine nicht supraleitende metallische Matrix eingebettet sind, und eine nicht-supraleitende, metallische Zone aufweist, dadurch gekennzeichnet, daß der spezifische Kalt-Widerstand der nicht supraleitenden metallischen Zone mindestens zweimal niedriger ist als der globale spezifische Kalt-Widerstand der supraleitenden Zone im nicht-supraleitenden Zustand, wobei die supraleitende Zone und die metallische, nicht-supraleitende Zone sich ohne Kohäsion in einfachem mechanischen Kontakt befinden.

2. Supraleiter nach Anspruch 1, dadurch gekennzeichnet, daß er aus einer einzigen Ader besteht, wobei die nicht-supraleitende, metallische Zone aus einer Seele (12), die sich im Zentrum einer einzigen supraleitenden Zone (11) befindet, und/oder einem Kranz (13) besteht, der die supraleitende Zone (11) umgibt.

3. Supraleiter nach Anspruch 1, dadurch gekennzeichnet, daß die supraleitende Zone aus einer oder mehreren supraleitenden Adern oder Bändern besteht, wobei die metallische, nicht-supraleitende Zone aus einer oder mehreren Adern oder Bändern besteht.

4. Supraleiter nach Anspruch 3, dadurch gekennzeichnet, daß die metallische, nicht-supraleitende Zone aus einer zentralen Ader (2) besteht, während die supraleitende Zone aus mehreren supraleitenden Adern (1) besteht, die um die zentrale Ader herum angeordnet sind.

## Claims

1. A superconductive conductor protected against partial transitions, the conductor comprising a superconductive region made up of superconductive filaments embedded in a non-superconductive metal matrix, and a non-superconductive metal region, the conductor being characterized in that the cold resistivity of the non-superconductive metal region is less than half the overall cold resistivity of the superconductive region in the non-superconductive state, the superconductive region and the non-superconductive metal region being merely in mechanical contact, without cohesion.

2. A superconductive conductor according to claim 1, characterized in that it is made up of a single strand, with the non-superconductive metal region being constituted by a core (12) situated in the middle of a single superconductive region (11) and/or by a sheath (13) surrounding the superconductive region (11).

3. A superconductive conductor according to claim 1, characterized in that the superconductive region is constituted by one or more superconductive tapes or strands, the non-superconductive metal region being constituted by one or more tapes or strands.

4. A superconductive conductor according to claim 3, characterized in that the non-superconductive metal region is constituted by a central strand (2), the superconductive region being constituted by a plurality of superconductive strands (1) disposed around the central strand.
